# EUROPÄISCHE PATENTSCHRIFT

(11) **EP 3 084 497 B1**
(45) Veröffentlichungstag und Bekanntmachung des Hinweises auf die Patenterteilung: **29.04.2020**
(21) Anmeldenummer: 14815316.6
(22) Anmeldetag: 15.12.2014
(51) Int. Cl.: G02B 19/00, G02B 3/00, G02B 6/42, G02B 27/09, H01S 5/40

(54) **VORRICHTUNG ZUR FORMUNG VON LASERSTRAHLUNG**
DEVICE FOR SHAPING LASER RADIATION
DISPOSITIF DE MISE EN FORME D'UN RAYONNEMENT LASER

(30) Priorität: 16.12.2013 DE 102013114083
(43) Veröffentlichungstag der Anmeldung: 26.10.2016
(73) Patentinhaber: LIMO GmbH, 44319 Dortmund (DE)
(72) Erfinder: MITRA, Thomas, 44309 Dortmund (DE)
(74) Vertreter: Basfeld, Rainer
(86) Internationale Anmeldenummer: PCT/EP2014/077822
(87) Internationale Veröffentlichungsnummer: WO 2015/091392

(56) Entgegenhaltungen:
- EP-A2- 2 309 309
- JP-A- 2004 061 949
- US-A- 5 333 077
- US-A1- 2011 002 042
- US-B1- 6 407 870

## Beschreibung

Die vorliegende Erfindung betrifft eine Vorrichtung zur Formung von Laserstrahlung gemäß dem Oberbegriff des Anspruchs 1.

Definitionen: In Ausbreitungsrichtung der Laserstrahlung meint mittlere Ausbreitungsrichtung der Laserstrahlung, insbesondere wenn diese keine ebene Welle ist oder zumindest teilweise divergent ist. Mit Laserstrahl, Lichtstrahl, Teilstrahl oder Strahl ist, wenn nicht ausdrücklich anderes angegeben ist, kein idealisierter Strahl der geometrischen Optik gemeint, sondern ein realer Lichtstrahl, wie beispielsweise ein Laserstrahl mit einem Gauß-Profil oder einem Top-Hat-Profil, der keinen infinitesimal kleinen, sondern einen ausgedehnten Strahlquerschnitt aufweist. Licht soll nicht nur den sichtbaren Spektralbereich, sondern auch den infraroten und ultravioletten Spektralbereich bezeichnen. Keilförmig soll nicht implizieren, dass plane Flächen vorliegen, sondern dass die Ausdehnung einer keilförmigen Struktur beim Fortschreiten in einer Richtung in einer oder zwei dazu senkrechten oder dazu geneigten Richtungen abnimmt oder zunimmt. Es sollen also von dem Begriff keilförmig sowohl plane Flächen wie beispielsweise Teilflächen von Keilen und Pyramiden, als auch gewölbte Flächen wie beispielsweise Teilflächen von Kegeln umfasst sein.

Eine Vorrichtung der eingangs genannten Art ist aus der US 5 333 077 A bekannt. Die darin beschriebenen Ausführungsformen weisen auf der Eintrittsseite der Vorrichtung eine eindimensionale Anordnung von Linsen und auf der Austrittsseite eine zweidimensionale Anordnung von Linsen auf. Zwischen den Linsen besteht in einigen der Ausführungsformen eine 1:1-Beziehung. Bei den Linsen handelt es sich um diffraktive Linsen, insbesondere um Fresnel-Zonenplatten.

Eine weitere Vorrichtung zur Formung von Laserstrahlung ist aus der EP 2 309 309 A2 bekannt. Diese Vorrichtung ist besonders gut geeignet, ein homogenes Nahfeld an einem Faserausgang zu erzeugen, das vorteilhaft bei dem Pumpen von Festkörperlasern ist. Der in der EP 2 309 309 A2 beschriebene monolithische Faserkoppler nutzt aus, dass in einigen Anwendungen nicht die theoretisch mögliche Brillanz aus einem Laserdiodenbarren gebraucht wird, sondern eine kleinere Brillanz ausreicht. Dann können die einzelnen Emitter des Laserdiodenbarrens mit einer Optik auf die Lichtleitfaser abgebildet werden. Dabei muss jedoch die Lichtleitfaser das Strahlparameterprodukt des gesamten Laserdiodenbarrens in der Slow-Axis transportieren können.

Das der vorliegenden Erfindung zugrunde liegende Problem ist die Schaffung einer Vorrichtung der eingangs genannten Art, die eine höhere Brillanz erreicht und/oder effektiver aufgebaut ist, wobei insbesondere das Produkt aus Kerndurchmesser und numerischer Apertur der Lichtleitfaser nur etwa dem Strahlparameterprodukt eines einzelnen Emitters des Laserdiodenbarrens in der Slow-Axis entsprechen muss.

Dies wird erfindungsgemäß durch eine Vorrichtung der eingangs genannten Art mit den kennzeichnenden Merkmalen des Anspruchs 1 erreicht. Die Unteransprüche betreffen bevorzugte Ausgestaltungen der Erfindung.

Gemäß Anspruch 1 ist vorgesehen, dass die Linsen des ersten Linsenarrays als Zylinderlinsen oder zylinderähnliche Linsen ausgebildet sind, wobei die Zylinderachsen von mindestens zwei der Zylinderlinsen oder zylinderähnlichen Linsen des ersten Linsenarrays einen Winkel größer 0° und kleiner 25° miteinander einschließen, und/oder dass die Linsen des zweiten Linsenarrays als Zylinderlinsen oder zylinderähnliche Linsen ausgebildet sind, wobei die Zylinderachsen von mindestens zwei der Zylinderlinsen oder zylinderähnlichen Linsen des zweiten Linsenarrays einen Winkel größer 0° und kleiner 25° miteinander einschließen.

Durch die Ausbildung als Zylinderlinsen kann erreicht werden, dass hinsichtlich der Abbildung oder Kollimation die Linsen des ersten Linsenarrays nur auf die Fast-Axis und die Linsen des zweiten Linsenarrays nur auf die Slow-Axis der Laserstrahlung des Laserdiodenbarrens wirken. Durch den Winkel zwischen den Zylinderachsen werden die von einzelnen in der Slow-Axis nebeneinander angeordneten Emittern eines Laserdiodenbarrens ausgehenden Laserstrahlungen in der ersten Richtung beziehungsweise der Slow-Axis-Richtung zur optischen Achse hin abgelenkt. Diese Ablenkung kann beispielsweise durch unterschiedliche keilförmige Strukturen der Linsen des ersten Linsenarrays in der ersten Richtung unterstützt werden.

Durch die unterschiedliche keilförmige Struktur hinsichtlich der zweiten Richtung der Linsen des ersten Linsenarrays wird erreicht, dass die von diesen ausgehende Laserstrahlung auf unterschiedliche der in der zweiten Richtung nebeneinander angeordneten Linsen des zweiten Linsenarrays auftreffen. Weiterhin wird durch die unterschiedliche keilförmige Struktur hinsichtlich der ersten Richtung der Linsen des zweiten Linsenarrays erreicht, dass die auf diese auftreffende Laserstrahlung wieder zur optischen Achse der Vorrichtung gebrochen werden.

Eine oder eine Mehrzahl der Linsen des ersten Linsenarrays können die von einzelnen Emittern eines Laserdiodenbarrens ausgehende Laserstrahlung hinsichtlich der zweiten Richtung ablenken, insbesondere so, dass die von unterschiedlichen Linsen des ersten Linsenarrays ausgehenden Laserstrahlungen auf unterschiedliche, in der zweiten Richtung zueinander beabstandete Linsen des zweiten Linsenarrays auftreffen.

Dabei kann insbesondere vorgesehen sein, dass das erste Linsenarray und/oder das zweite Linsenarray so gestaltet sind, dass durch eine Linse des ersten Linsenarrays hindurchgetretene Laserstrahlung genau durch eine Linse des zweiten Linsenarrays hindurch tritt, wobei insbesondere die Anzahl der Linsen des ersten Linsenarrays der Anzahl der Linsen des zweiten Linsenarrays entspricht. Wenn dann die Vorrichtung zur Formung der von einem Laserdiodenbarren oder einem Stack von Laserdiodenbarren ausgehenden Laserstrahlung genutzt wird, entspricht die erste Richtung der Slow-Axis und die zweite Richtung der Fast-Axis. Bei einer derartigen Gestaltung wird die Laserstrahlung von jedem Emitter des Laserdiodenbarrens auf der Eintrittsfläche auf eine angepasste Linse treffen, die zusätzlich zur Kollimation oder Abbildung auch einen Winkel in Fast-Axis-Richtung und in Slow-Axis-Richtung auf den Poyntingvektor der Laserstrahlung aufprägt. Auf der Eintrittsfläche des Bauteils entspricht dabei die Anzahl der entlang der Slow-Axis nebeneinander angeordneten Linsen der Anzahl der Emitter des Laserdiodenbarrens. Der in Fast-Axis-Richtung und in Slow-Axis-Richtung auf den Poyntingvektor der Laserstrahlung aufprägte Winkel kann insbesondere so gewählt werden, dass die Laserstrahlung der Emitter auf der Austrittsfläche des Bauteils in Richtung der Fast-Axis auf unterschiedliche Linsen trifft. Auch auf der Austrittsfläche des Bauteils entspricht somit die Anzahl der entlang der Fast-Axis übereinander angeordneten Linsen der Anzahl der Emitter des Laserdiodenbarrens.

Es besteht die Möglichkeit, dass die Eintrittsfläche in der ersten Richtung ausgedehnter ist als die Austrittsfläche und/oder dass die Austrittsfläche in der zweiten Richtung ausgedehnter ist als die Eintrittsfläche. Auf diese Weise wird den in unterschiedlichen Richtungen nebeneinander angeordneten Linsen auf der Eintrittsfläche und der Austrittsfläche Rechnung getragen.

Es kann weiterhin vorgesehen sein, dass die Linsen des ersten Linsenarrays in der zweiten Richtung versetzt zueinander angeordnet sind und/oder dass die Linsen des zweiten Linsenarrays in der ersten Richtung versetzt zueinander angeordnet sind. Diese Versetzungen wirken ähnlich wie die keilförmigen Strukturen und unterstützen diese bei der Ablenkung der Laserstrahlungen.

Dabei besteht insbesondere die Möglichkeit, dass mindestens eine der Zylinderachsen der Zylinderlinsen oder zylinderähnlichen Linsen des ersten Linsenarrays senkrecht zu mindestens einer der Zylinderachsen der Zylinderlinsen oder zylinderähnlichen Linsen des zweiten Linsenarrays ausgerichtet ist.

Weiterhin kann vorgesehen sein, dass die Zylinderachsen der Zylinderlinsen oder zylinderähnlichen Linsen des ersten Linsenarrays entweder parallel zu der ersten Richtung sind oder einen Winkel von weniger als 45°, vorzugsweise weniger als 35°, insbesondere weniger als 25° mit der ersten Richtung einschließen und/oder dass die Zylinderachsen der Zylinderlinsen oder zylinderähnlichen Linsen des zweiten Linsenarrays entweder parallel zu der zweiten Richtung sind oder einen Winkel von weniger als 45°, vorzugsweise weniger als 35°, insbesondere weniger als 25° mit der zweiten Richtung einschließen.

Dabei kann vorgesehen sein, dass die Zylinderachsen von mindestens zwei der Zylinderlinsen oder zylinderähnlichen Linsen des ersten Linsenarrays einen Winkel größer 0° und kleiner 15°, insbesondere einen Winkel größer 0° und kleiner 10° miteinander einschließen und/oder dass die Zylinderachsen von mindestens zwei der Zylinderlinsen oder zylinderähnlichen Linsen des zweiten Linsenarrays einen Winkel größer 0° und kleiner 15°, insbesondere einen Winkel größer 0° und kleiner 10° miteinander einschließen.

Es besteht insbesondere die Möglichkeit, dass mindestens eine der Zylinderlinsen oder zylinderähnlichen Linsen des ersten Linsenarrays derart ausgebildet ist, dass sie die von einem Emitter des Laserdiodenbarrens oder des Stacks von Laserdiodenbarren ausgehende Laserstrahlung hinsichtlich der zweiten Richtung auf die Eintrittsfläche einer Lichtleitfaser abbilden oder hinsichtlich der zweiten Richtung kollimieren kann und/oder dass mindestens eine der Zylinderlinsen oder zylinderähnlichen Linsen des zweiten Linsenarrays derart ausgebildet ist, dass sie die von einem Emitter des Laserdiodenbarrens oder des Stacks von Laserdiodenbarren ausgehende Laserstrahlung hinsichtlich der ersten Richtung auf die Eintrittsfläche einer Lichtleitfaser abbilden oder hinsichtlich der ersten Richtung kollimieren kann. Insbesondere durch die Abbildungen hinsichtlich der Fast-Axis und der Slow-Axis kann mit einem einzelnen Bauteil die Laserstrahlung eines Laserdiodenbarrens mit hoher Brillanz in eine Lichtleitfaser eingekoppelt werden.

Dabei ist es besonders vorteilhaft, wenn das Bauteil ein monolithisches Bauteil ist.

Es kann vorgesehen sein, dass die Linsen des ersten Linsenarrays und/oder die Linsen des zweiten Linsenarrays im Wesentlichen jeweils die Laserstrahlung nur hinsichtlich der ersten oder hinsichtlich der zweiten Richtung formen. Es besteht aber auch die Möglichkeit, dass die Linsen des ersten Linsenarrays und/oder die Linsen des zweiten Linsenarrays jeweils die Laserstrahlung sowohl hinsichtlich der ersten, als auch hinsichtlich der zweiten Richtung formen.

Insbesondere kann vorgesehen sein, dass die Linsen des ersten Linsenarrays die Laserstrahlung hinsichtlich der zweiten Richtung, die beispielsweise der Fast-Axis entsprechen kann, kollimieren und dass die Linsen des zweiten Linsenarrays hinsichtlich der zweiten Richtung fokussieren und hinsichtlich der ersten Richtung, die beispielsweise der Slow-Axis entsprechen kann, die Laserstrahlung abbilden. Dabei können bei den Linsen des zweiten Linsenarrays unterschiedliche Krümmungen hinsichtlich der ersten und der zweiten Richtung vorgesehen sein.

Es besteht alternativ oder zusätzlich die Möglichkeit, dass die Linsen des ersten und des zweiten Linsenarrays jeweils in einer Achse als Teleskop, wie beispielsweise ein Galileiteleskop oder ein Keplerteleskop oder wie eine dicke Linse, funktionieren.

Bei einer weiteren Ausführungsform besteht die Möglichkeit, dass die Optik wie zuvor beschrieben arbeitet, dass jedoch aus den Linsen des zweiten Linsenarrays kollimiertes und umsortiertes Licht heraustritt. Dieses Licht wird dann mittels einer, insbesondere preiswerten runden Linse fokussiert.

Bei der kollimierenden Ausführung ist es besonders vorteilhaft, in der Fast-Axis eine Teleskopanordnung für jeden Emitter aufzubauen und nur in der Slow-Axis zu kollimieren. Damit lässt sich die Randbedingung, dass der Abstand zwischen den Emittern und der Optik einerseits und die Dicke der Optik für beide Achsen andererseits gleich sein muss, so erfüllen, dass die Strahlqualität der Quelle in beiden Achsen erhalten bleibt. Mit Strahlqualität beziehungsweise Strahlparameterprodukt (SPP) ist auf der Quellenseite das Produkt aus Strahlradius in der Taille und halbem Fernfeldwinkel gemeint. Auf der Seite des Fasereingangs ist damit das Produkt aus Strahlradius am Faserort und halbem Fernfeldwinkel gemeint. Bei ungünstiger Wahl der Optikparameter, wie im Stand der Technik üblich, gelingt es im Allgemeinen nicht, dass dieses Produkt am Faserort in beiden Achsen dem Strahlparameterprodukt der Quelle entspricht.

Es besteht durchaus die Möglichkeit, dass die erfindungsgemäße Vorrichtung nicht das von einem Laserdiodenbarren ausgehende Licht, sondern das von beliebigen anderen Laserlichtquellen ausgehende Licht formen kann. Beispielsweise könnten beliebige Reihen von Lasern oder nebeneinander angeordnete Faserausgänge, aus denen Laserlicht austritt, oder Quantenkaskadenlaser vorgesehen sein.

Es kann vorgesehen sein, dass die Linsen als verkippte und/oder dezentrierte Zylinderlinsen gestaltet sind oder dass sie beliebige Freiformflächen aufweisen.

Es besteht weiterhin die Möglichkeit, dass die Linsenmitten der Linsen des ersten Linsenarrays unterschiedliche Abstände zu der ihren zugeordneten Lichtquelle aufweisen. Das ist vorteilhaft, weil die optischen Wege beispielsweise vom jeweiligen Emitter eines Laserdiodenbarrens bis zur Rückseite der Vorrichtung sonst deutlich verschieden sein können. Dies würde aber die Abbildung hinsichtlich der zweiten Richtung beziehungsweise der Slow-Axis deutlich schwieriger gestalten.

Es besteht die Möglichkeit, die Oberflächen der Linsen beispielsweise durch erweiterte Polynome (Extended Polynomial) zu beschreiben. Beispielsweise können dabei lineare Terme in der ersten und der zweiten Richtung für die Keilfunktionen benutzt werden. Weiterhin können Terme mit geraden Exponenten in der ersten Richtung für die Krümmung hinsichtlich der ersten Richtung und Terme mit geraden Exponenten in der zweiten Richtung für die Krümmung hinsichtlich der zweiten Richtung benutzt werden. Es kann durchaus vorgesehen werden, mit hinsichtlich der ersten und der zweiten Richtung gemischten Terme die Gestaltung der Oberflächen weiter zu verbessern.

Mit geeigneter Software können die Linsenelemente als beliebige Freiformelemente optimiert werden.

Die Erfindung wird unter Bezugnahme auf die beiliegenden Abbildungen näher beschrieben. Es zeigt:
- Fig. 1: eine perspektivische Ansicht einer ersten Ausführungsform einer erfindungsgemäßen Vorrichtung;
- Fig. 2: eine Vorderansicht der Vorrichtung gemäß Fig. 1;
- Fig. 3: eine Fig. 1 entsprechende Ansicht auf die Vorrichtung mit schematisch angedeuteter Laserstrahlung;
- Fig. 4: eine Draufsicht auf die Vorrichtung gemäß Fig. 1 mit schematisch angedeuteter Laserstrahlung;
- Fig. 5: eine Seitenansicht der Vorrichtung gemäß Fig. 1 mit schematisch angedeuteter Laserstrahlung;
- Fig. 6: eine perspektivische Prinzipskizze der Vorrichtung gemäß Fig. 1 mit schematisch angedeuteter Laserstrahlung, bei der die Funktion der einzelnen Linsen verdeutlicht wird;
- Fig. 7: eine Vorderansicht der Prinzipskizze gemäß Fig. 6 mit schematisch angedeuteter Laserstrahlung;
- Fig. 8: eine Draufsicht der Prinzipskizze gemäß Fig. 6 mit schematisch angedeuteter Laserstrahlung;
- Fig. 9: eine Seitenansicht der Prinzipskizze gemäß Fig. 6 mit schematisch angedeuteter Laserstrahlung;
- Fig. 10: eine perspektivische Vorderansicht einer zweiten Ausführungsform einer erfindungsgemäßen Vorrichtung;
- Fig. 11: eine Detailvergrößerung der Eintrittsfläche der Vorrichtung gemäß Fig. 10;
- Fig. 12: eine perspektivische Rückansicht der Vorrichtung gemäß Fig. 10;
- Fig. 13: eine Draufsicht auf den Bereich der Austrittsfläche der Vorrichtung gemäß Fig. 10.

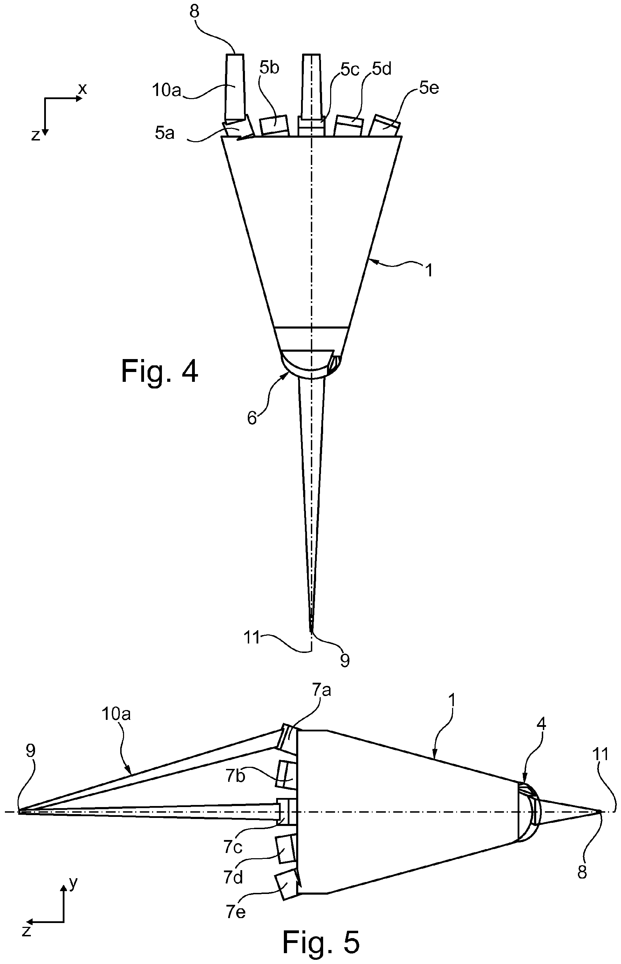

In den Figuren sind gleiche oder funktional gleiche Teile oder Lichtstrahlen mit gleichen Bezugszeichen versehen. Weiterhin sind in den Figuren zur besseren Orientierung kartesische Koordinatensysteme eingezeichnet. Weiterhin ist zur Verdeutlichung in Fig. 4 und Fig. 5 eine optische Achse 11 angedeutet.

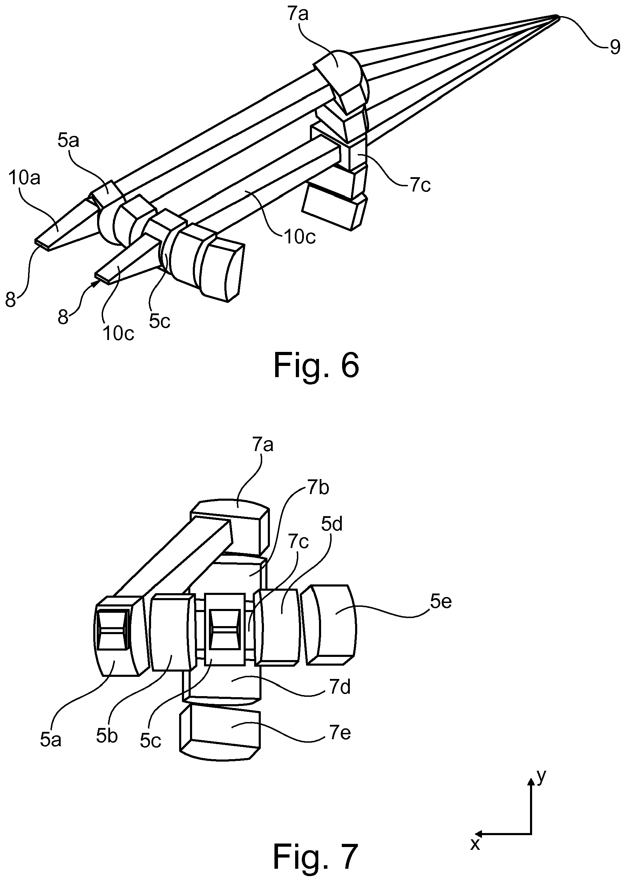

Die Fig. 6 bis Fig. 9 verdeutlichen lediglich skizzenhaft die optisch funktionalen Linsenoberflächen und stellen diese als separate Bauteile dar. Die erfindungsgemäße Vorrichtung sieht jedoch wie im Nachfolgenden detailliert beschrieben ein Substrat oder monolithisches Bauteil vor, in die die Linsenoberflächen integriert sind.

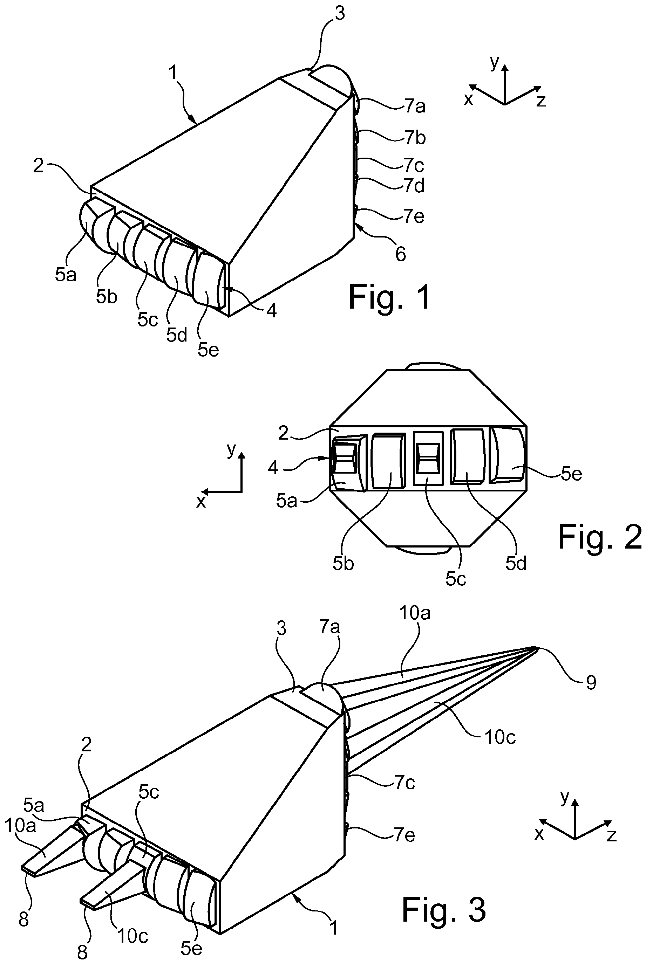

Die in den Fig. 1 bis Fig. 5 abgebildete Vorrichtung ist als monolithisches transparentes Bauteil 1 mit einer Eintrittsfläche 2 und einer Austrittsfläche 3 ausgebildet. Dabei sind die Eintrittsfläche 2 und die Austrittsfläche 3 in Z-Richtung des eingezeichneten Koordinatensystems einander gegenüberliegend angeordnet (siehe Fig. 1). Die Z-Richtung entspricht also der Ausbreitungsrichtung der zu formenden Laserstrahlung.

Auf der Eintrittsfläche 2 ist ein erstes Linsenarray 4 angeordnet, das eine Mehrzahl von in einer ersten Richtung, die der X-Richtung des eingezeichneten Koordinatensystems entspricht, nebeneinander angeordnete Linsen 5a, 5b, 5c, 5d, 5e aufweist. In den Abbildungen sind zur einfachen Darstellung jeweils nur fünf Linsen 5a, 5b, 5c, 5d, 5e abgebildet. Es können jedoch durchaus mehr oder weniger als fünf Linsen vorgesehen sein.

Die Linsen 5a, 5b, 5c, 5d, 5e sind in einer zweiten Richtung, die der Y-Richtung des eingezeichneten Koordinatensystems entspricht, versetzt zueinander angeordnet (siehe Fig. 2). Dabei ist die in Fig. 2 am linken Rand angeordnete Linse 5a hinsichtlich der Y-Richtung am unteren Rand der Eintrittsfläche 2 angeordnet, wohingegen die am rechten Rand angeordnete Linse 5e hinsichtlich der Y-Richtung am oberen Rand der Eintrittsfläche 2 angeordnet ist. Die mittlere Linse 5c ist auch hinsichtlich der Y-Richtung etwa in der Mitte angeordnet. Die beiden Linsen 5b und 5d nehmen hinsichtlich der Y-Richtung jeweils Zwischenpositionen zwischen den äußeren Linsen 5a, 5e und der mittleren Linse 5c ein.

Weiterhin unterscheiden sich die Linsen 5a, 5b, 5c, 5d, 5e des ersten Linsenarrays 4 durch eine jeweils unterschiedliche keilförmige Struktur in Y-Richtung voneinander. Fig. 1 zeigt, dass die links angeordnete Linse 5a an ihrem hinsichtlich der Y-Richtung oberen Rand in Z-Richtung ausgedehnter ist als an ihrem unteren Rand. Die rechts angeordnete Linse 5e ist an ihrem hinsichtlich der Y-Richtung oberen Rand in Z-Richtung weniger ausgedehnt als an ihrem unteren Rand. Die übrigen Linsen 5b, 5c, 5d nehmen Zwischenwerte ein.

Die Linsen 5a, 5b, 5c, 5d, 5e des ersten Linsenarrays 4 sind als Zylinderlinsen oder zylinderähnliche Linsen ausgebildet, wobei sich deren Zylinderachsen zumindest teilweise in X-Richtung erstrecken. Dabei ist die Zylinderachse der mittleren Linse 5c parallel zur X-Richtung, wohingegen die Zylinderachsen der anderen Linsen 5a, 5b, 5d, 5e mit der X-Richtung einen Winkel größer 0° einschließen.

So zeigt insbesondere die Fig. 4, dass die Zylinderachsen der beiden äußeren Linsen 5a und 5e einen Winkel von etwa 20° beziehungsweise -20° mit der X-Richtung einschließen. Weiterhin zeigt die Fig. 4, dass die Zylinderachsen der beiden Linsen 5b und 5d einen Winkel von etwa 10° beziehungsweise -10° mit der X-Richtung einschließen.

Die unterschiedliche Ausrichtung der Zylinderachsen der Linsen 5a, 5b, 5c, 5d, 5e des ersten Linsenarrays 4 kann von einer unterschiedlichen keilförmigen Struktur der Linsen 5a, 5b, 5c, 5d, 5e in der X-Richtung begleitet sein, wie dies beispielsweise aus Fig. 1 ersichtlich ist.

Auf der Austrittsfläche 3 ist ein zweites Linsenarray 6 angeordnet, das eine Mehrzahl von in der zweiten Richtung, die der Y-Richtung des eingezeichneten Koordinatensystems entspricht, nebeneinander angeordnete Linsen 7a, 7b, 7c, 7d, 7e aufweist. In den Abbildungen sind zur einfachen Darstellung jeweils nur fünf Linsen 7a, 7b, 7c, 7d, 7e abgebildet. Es können jedoch durchaus mehr oder weniger als fünf Linsen vorgesehen sein.

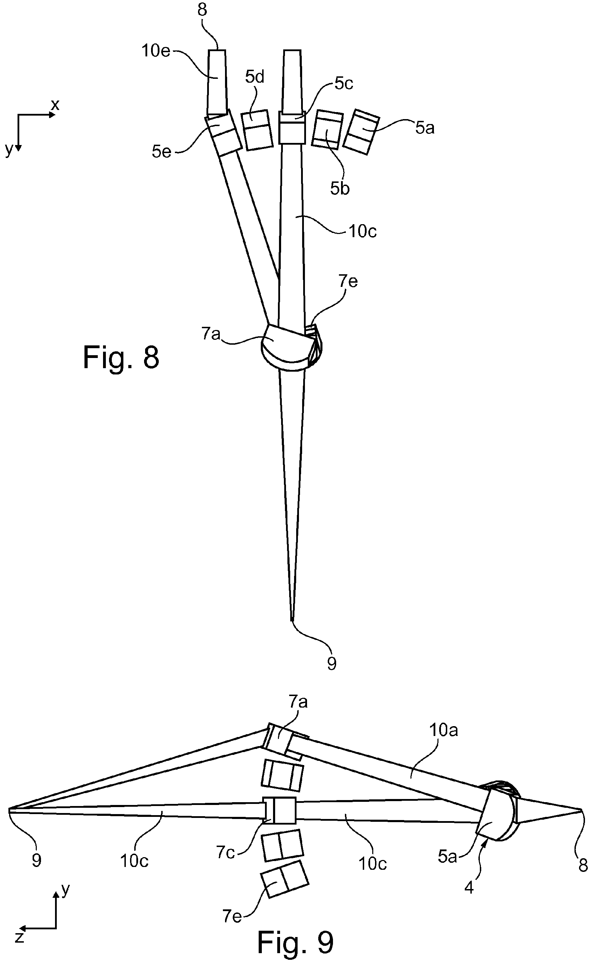

Die Linsen 7a, 7b, 7c, 7d, 7e sind in der ersten Richtung, die der X-Richtung des eingezeichneten Koordinatensystems entspricht, versetzt zueinander angeordnet (siehe dazu Fig. 8). Dabei ist die in Fig. 8 am oberen Rand angeordnete Linse 7a hinsichtlich der X-Richtung am rechten Rand der Austrittsfläche 3 angeordnet, wohingegen die am unteren Rand angeordnete Linse 7e hinsichtlich der X-Richtung am linken Rand der Eintrittsfläche 2 angeordnet ist. Die mittlere Linse 7c ist auch hinsichtlich der X-Richtung etwa in der Mitte angeordnet. Die beiden Linsen 7b und 7d nehmen hinsichtlich der X-Richtung jeweils Zwischenpositionen zwischen den äußeren Linsen 7a, 7e und der mittleren Linse 7c ein.

Weiterhin unterscheiden sich die Linsen 7a, 7b, 7c, 7d, 7e des zweiten Linsenarrays 6 durch eine jeweils unterschiedliche keilförmige Struktur in X-Richtung voneinander. Fig. 7 zeigt, dass die oben angeordnete Linse 7a an ihrem hinsichtlich der X-Richtung linken Rand in Z-Richtung ausgedehnter ist als an ihrem rechten Rand. Die unten angeordnete Linse 7e ist an ihrem hinsichtlich der X-Richtung linken Rand in Z-Richtung weniger ausgedehnt ist als an ihrem rechten Rand. Die übrigen Linsen 7b, 7c, 7d nehmen Zwischenwerte ein.

Die Linsen 7a, 7b, 7c, 7d, 7e des zweiten Linsenarrays 6 sind als Zylinderlinsen oder zylinderähnliche Linsen ausgebildet, wobei sich deren Zylinderachsen zumindest teilweise in Y-Richtung erstrecken. Dabei ist die Zylinderachse der mittleren Linse 7c parallel zur Y-Richtung, wohingegen die Zylinderachsen der anderen Linsen 7a, 7b, 7d, 7e mit der Y-Richtung einen Winkel größer 0° einschließen.

So zeigt insbesondere die Fig. 5, dass die Zylinderachsen der beiden äußeren Linsen 7a und 7e einen Winkel von etwa 20° beziehungsweise -20° mit der Y-Richtung einschließen. Weiterhin zeigt die Fig. 5, dass die Zylinderachsen der beiden Linsen 7b und 7d einen Winkel von etwa 10° beziehungsweise -10° mit der Y-Richtung einschließen.

Die unterschiedliche Ausrichtung der Zylinderachsen der Linsen 7a, 7b, 7c, 7d, 7e des zweiten Linsenarrays 6 kann von einer unterschiedlichen keilförmigen Struktur der Linsen 7a, 7b, 7c, 7d, 7e in der Y-Richtung begleitet sein, wie dies beispielsweise aus Fig. 5 ersichtlich ist.

Die abgebildete Vorrichtung kann insbesondere die von einem nicht abgebildeten Laserdiodenbarren ausgehende Laserstrahlung 10a, 10b, 10c, 10d, 10e formen, dessen einzelne Emitter jeweils in den mit dem Bezugszeichen 8 versehenen Positionen in den Fig. 3 bis Fig. 6 sowie Fig. 8 und Fig. 9 angeordnet sein können. Dabei entspricht die X-Richtung der Slow-Axis und die Y-Richtung der Fast-Axis des Laserdiodenbarrens.

Weiterhin ist in den Fig. 3 bis Fig. 6 sowie Fig. 8 und Fig. 9 mit dem Bezugszeichen 9 eine Position versehen, an deren Stelle beispielsweise die Eintrittsfläche einer nicht abgebildeten Lichtleitfaser angeordnet sein kann.

Die Linsen 5a, 5b, 5c, 5d, 5e des ersten Linsenarrays 4 und die Linsen 7a, 7b, 7c, 7d, 7e des zweiten Linsenarrays 6 dienen jeweils sowohl zur Ablenkung der auf sie auftreffenden Laserstrahlung 10a, 10b, 10c, 10d, 10e, als auch zur Abbildung oder Kollimation der Laserstrahlung 10a, 10b, 10c, 10d, 10e. Insbesondere die Prinzipskizze gemäß Fig. 9 verdeutlicht, dass die Linsen 5a, 5b, 5c, 5d, 5e des ersten Linsenarrays 4 die von den nicht abgebildeten einzelnen Emittern (siehe Bezugszeichen 8) ausgehende Laserstrahlung 10a, 10b, 10c, 10d, 10e hinsichtlich der Fast-Axis beziehungsweise der Y-Richtung jeweils auf die nicht abgebildete Eintrittsfläche (siehe Bezugszeichen 9) der Lichtleitfaser abbilden können.

Gleichzeitig bewirken die verkippten Zylinderachsen der außermittigen Linsen 5a, 5b, 5d, 5e des ersten Linsenarrays 4, dass die von diesen ausgehende Laserstrahlung 10a, 10b, 10d, 10e in X-Richtung zur optische Achse 11 hin abgelenkt wird (siehe Fig. 4, Fig. 6 und Fig. 8) und auf die Linsen 7a, 7b, 7d, 7e des zweiten Linsenarrays 6 auftrifft. Dabei ist insbesondere einer jeden Linse 5a, 5b, 5c, 5d, 5e des ersten Linsenarrays 4 genau eine Linse 7a, 7b, 7c, 7d, 7e des zweiten Linsenarrays 6 derart zugeordnet, dass die durch eine der Linsen 5a, 5b, 5c, 5d, 5e des ersten Linsenarrays 4 hindurchgetretene Laserstrahlung 10a, 10b, 10d, 10e durch genau eine Linse 7a, 7b, 7c, 7d, 7e des zweiten Linsenarrays 6 hindurch tritt. Dies ist anschaulich in Fig. 6 verdeutlicht.

Zusätzlich bewirken die jeweils unterschiedlichen keilförmigen Strukturen der außermittigen Linsen 5a, 5b, 5d, 5e des ersten Linsenarrays 4, dass die von diesen ausgehende Laserstrahlung 10a, 10b, 10d, 10e von der optische Achse 11 weg nach oben und nach unten in Y-Richtung abgelenkt wird (siehe Fig. 5, Fig. 6 und Fig. 9) und auf die entsprechenden Linsen 7a, 7b, 7d, 7e des zweiten Linsenarrays 6 auftrifft.

An dieser Stelle soll angemerkt werden, dass die mittlere Linse 5c des ersten Linsenarrays 4 weder eine verkippte Zylinderachse, noch eine keilförmige Struktur aufweist, so dass die durch diese Linse 5c hindurchtretende Laserstrahlung 10c weder hinsichtlich der X-Richtung, noch hinsichtlich der Y-Richtung abgelenkt wird und daher auf die mittlere Linse 7c des zweiten Linsenarrays 6 auftrifft (siehe Fig. 6). Sie wird dabei lediglich hinsichtlich der Fast-Axis auf die nicht abgebildete Eintrittsfläche (siehe Bezugszeichen 9) der Lichtleitfaser abgebildet.

In dem abgebildeten Ausführungsbeispiel wird eine durch die in Fig. 6 links angeordnete Linse 5a hindurch tretende Laserstrahlung 10a nach oben auf die oberste Linse 7a abgelenkt sowie die durch die nächste Linse 5b hindurch tretende Laserstrahlung 10b auf die unterhalb der Linse 7a angeordnete Linse 7b und so weiter. Es besteht die Möglichkeit, dass diese Reihenfolge vertauscht wird. Weiterhin muss die Ablenkung der Laserstrahlungen 10a, 10b, 10c, 10d, 10e nicht "übersichtlich sortiert" sein. Es besteht beispielsweise durchaus die Möglichkeit, das von zwei benachbarten Linsen 5a, 5b des ersten Linsenarrays 4 ausgehende Laserstrahlung 10a, 10b nicht auf benachbarte Linsen des zweiten Linsenarrays 6 auftrifft. Vielmehr können die Linsenarrays 4, 6 so gestaltet sein und damit die Laserstrahlungen so abgelenkt werden, dass die optischen Weglängen der verschiedenen Strahlengänge besonders vorteilhaft sind.

Weiterhin zeigt die Prinzipskizze gemäß Fig. 8, dass die Linsen 7a, 7b, 7c, 7d, 7e des zweiten Linsenarrays 6 die von den nicht abgebildeten einzelnen Emittern (siehe Bezugszeichen 8) ausgehende Laserstrahlung 10a, 10b, 10c, 10d, 10e hinsichtlich der Slow-Axis beziehungsweise der X-Richtung jeweils auf die nicht abgebildete Eintrittsfläche (siehe Bezugszeichen 9) der Lichtleitfaser abbilden können.

Gleichzeitig bewirken die verkippten Zylinderachsen der außermittigen Linsen 7a, 7b, 7d, 7e des zweiten Linsenarrays 6, dass die von den außermittigen Linsen 5a, 5b, 5d, 5e des ersten Linsenarrays 4 ausgehende Laserstrahlung 10a, 10b, 10d, 10e in X-Richtung so abgelenkt wird, dass sie in einer Y-Z-Ebene verläuft (siehe Fig. 8).

Zusätzlich bewirken die jeweils unterschiedlichen keilförmigen Strukturen der außermittigen Linsen 7a, 7b, 7d, 7e des zweiten Linsenarrays 6, dass die von den außermittigen Linsen 5a, 5b, 5d, 5e des ersten Linsenarrays 4 ausgehende Laserstrahlung 10a, 10b, 10d, 10e in Y-Richtung zur optischen Achse 11 hin nach oben und nach unten abgelenkt wird (siehe Fig. 9) und auf die nicht abgebildete Eintrittsfläche (siehe Bezugszeichen 9) der Lichtleitfaser auftrifft.

An dieser Stelle soll angemerkt werden, dass die mittlere Linse 7c des zweiten Linsenarrays 6 ebenfalls weder eine verkippte Zylinderachse, noch eine keilförmige Struktur aufweist, so dass die durch diese Linse 7c hindurchtretende Laserstrahlung 10c weder hinsichtlich der X-Richtung, noch hinsichtlich der Y-Richtung abgelenkt wird (siehe Fig. 6). Sie wird vielmehr lediglich hinsichtlich der Slow-Axis auf die nicht abgebildete Eintrittsfläche (siehe Bezugszeichen 9) der Lichtleitfaser abgebildet.

Es besteht alternativ die Möglichkeit, dass die Linsen 5a, 5b, 5c, 5d, 5e des ersten Linsenarrays 4 und/oder die Linsen 7a, 7b, 7c, 7d, 7e des zweiten Linsenarrays 6 die von den einzelnen Emittern ausgehende Laserstrahlung nicht abbilden, sondern kollimieren. Die hinsichtlich Slow-Axis und Fast-Axis kollimierte Laserstrahlung kann anschließend mittels preisgünstiger, sphärischer Optik beispielsweise auf die Eintrittsfläche einer Lichtleitfaser fokussiert werden.

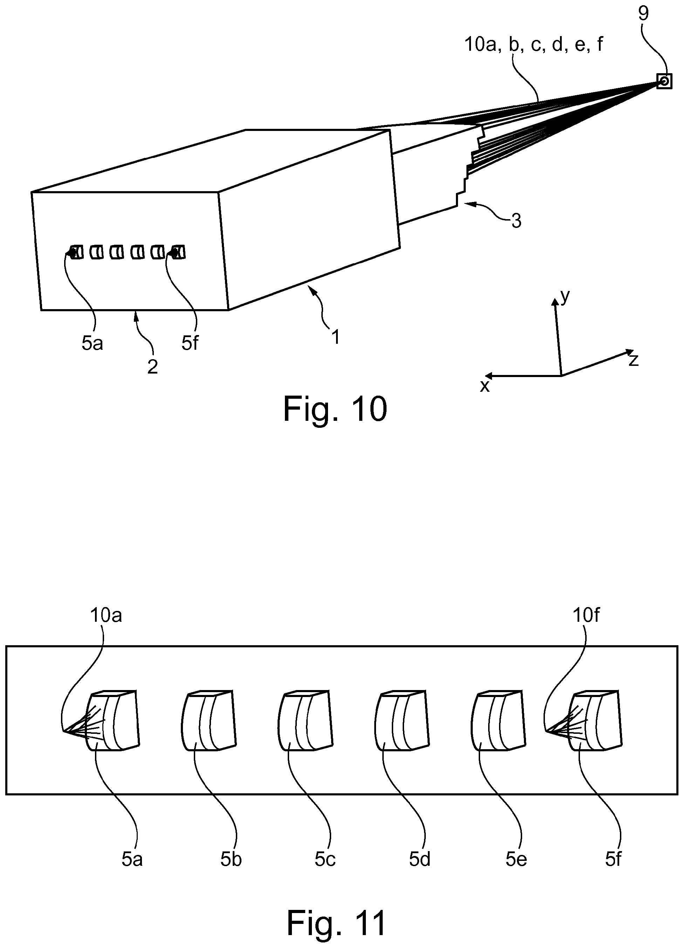

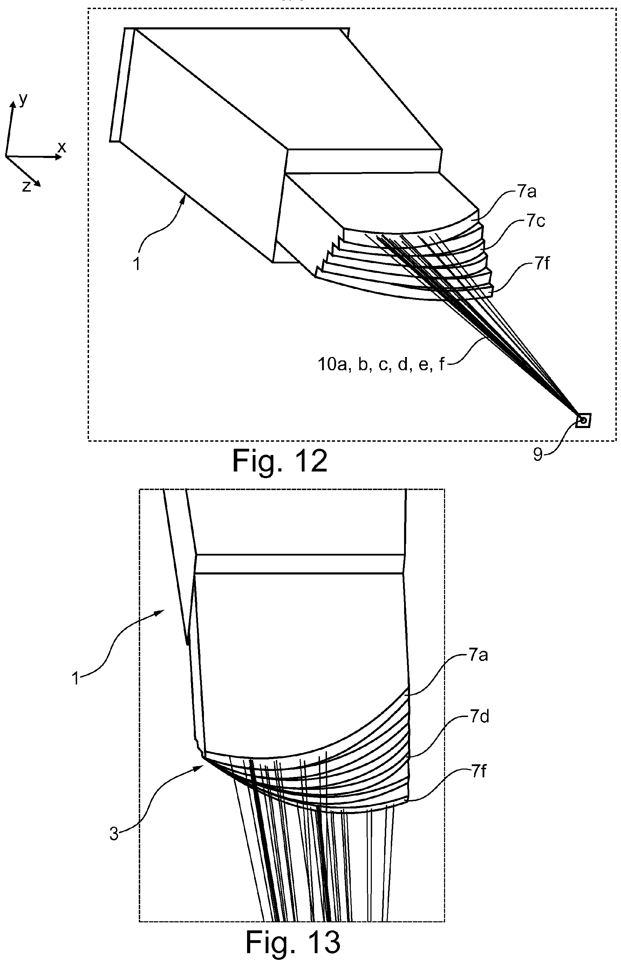

Das in Fig. 10 bis 13 abgebildete Ausführungsbeispiel einer erfindungsgemäßen Vorrichtung 1 ist ebenfalls als monolithisches transparentes Bauteil 1 mit einer Eintrittsfläche 2 und einer Austrittsfläche 3 ausgebildet. Dabei sind die Eintrittsfläche 2 und die Austrittsfläche 3 in Z-Richtung des eingezeichneten Koordinatensystems einander gegenüberliegend angeordnet (siehe Fig. 10). Die Z-Richtung entspricht also der Ausbreitungsrichtung der zu formenden Laserstrahlung.

Bei dem in den Fig. 10 bis 13 abgebildeten Ausführungsbeispiel einer erfindungsgemäßen Vorrichtung 1 sind sowohl auf der Eintrittsfläche 2, als auch auf der Austrittsfläche 3 jeweils sechs Linsen 5a, 5b, 5c, 5d, 5e, 5f des ersten Linsenarrays 4 und sechs Linsen 7a, 7b, 7c, 7d, 7e, 7f des zweiten Linsenarrays 6 dargestellt. Es können jedoch durchaus mehr oder weniger als sechs Linsen vorgesehen sein. Vorzugsweise können 3 bis 49 Linsen, insbesondere 8 bis 11 Linsen verwendet werden.

Beispielsweise können 10 Linsen vorgesehen sein, die die Laserstrahlung eines nicht abgebildeten Minilaserdiodenbarren mit 10 Emittern formen können. Insbesondere können bei diesem Minilaserdiodenbarren die Emitter eine Breite in X-Richtung von 100 µm und einen Mittenabstand von 500 µm aufweisen.

Bei der in Fig. 10 bis Fig. 13 abgebildeten Ausführungsform sind die sechs Linsen 5a, 5b, 5c, 5d, 5e, 5f voneinander verschieden, wobei jeweils Paare von Linsen 5a, 5f; 5b, 5e; 5c, 5d spiegelsymmetrisch zueinander sind. Die Linsen 5a, 5b, 5c, 5d, 5e, 5f weisen jeweils sowohl eine Krümmung in X-Richtung, als auch eine Krümmung in Y-Richtung auf. Weiterhin weisen sie eine im wesentlichen konvexe Form auf und lenken die Laserstrahlung 10a, 10b, 10c, 10d, 10e, 10f eines jeden der Emitter in X- und in Y-Richtung ab. Insbesondere weisen die Linsen 5a, 5b, 5c, 5d, 5e, 5f dabei auch die im Zusammenhang mit den Fig. 1 bis Fig. 9 beschriebene keilförmige Struktur auf.

Die Oberflächen der Linsen 5a, 5b, 5c, 5d, 5e, 5f können durch gemischte Polynome beschrieben werden, bei denen nicht nur gerade Terme je Achse vorkommen, sondern auch gemischte Terme in X und Y. Auch ungerade Terme in X und Y höher als nur in der ersten Ordnung können notwendig sein.

Die Linsen sind in X-Richtung nebeneinander angeordnet. Die Scheitelpunkte der Linsen 5a, 5b, 5c, 5d, 5e, 5f sind nicht notwendig auf einer Linie, wobei allerdings die Linsenaperturen sehr wohl symmetrisch zu den Mitten der einzelnen Emitter sind.

Die generelle Form der Linsen 7a, 7b, 7c, 7d, 7e, 7f auf der Austrittsfläche 3 ist ähnlich zu derjenigen der Linsen 5a, 5b, 5c, 5d, 5e, 5f auf der Eintrittsfläche 2. Insbesondere sind die Linsen 7a, 7b, 7c, 7d, 7e, 7f ebenfalls konvex, weisen Krümmungen in beiden Achsen X, Y auf und lassen sich durch gerade und ungerade gemischte Polynomterme in X und Y beschreiben.

Die Breite in X-Richtung ist typisch deutlich größer als auf der Eintrittsfläche 2. Beispielsweise kann die Breite der Linsen 5a, 5b, 5c, 5d, 5e, 5f auf der Eintrittsfläche 2 in X-Richtung jeweils weniger als 500 µm betragen, wohingegen die Breite der Linsen 7a, 7b, 7c, 7d, 7e, 7f auf der Austrittsfläche 3 in X-Richtung 500 µm bis 2500 µm betragen kann. Die Höhe der Linsen 5a, 5b, 5c, 5d, 5e, 5f; 7a, 7b, 7c, 7d, 7e, 7f auf der Eintrittsfläche 2 und der Austrittsfläche 3 in Y-Richtung liegt typisch im Bereich von 100 µm bis 1000 µm, insbesondere zwischen 200 µm und 600 µm.

Die Fig. 10 bis 13 zeigen, dass die Linsen 5a, 5b, 5c, 5d, 5e, 5f; 7a, 7b, 7c, 7d, 7e, 7f auf der Eintrittsfläche 2 und der Austrittsfläche 3 in zwei Achsen X, Y gekrümmt und als Freiformflächen ausgebildet sind. Weiterhin ist ersichtlich, dass das Bauteil 1 monolithisch ist. Die Scheitelpunkte der Linsen 7a, 7b, 7c, 7d, 7e, 7f auf der Austrittsfläche 3 sind näher an der optischen Achse angeordnet als die Scheitelpunkte der Linsen 5a, 5b, 5c, 5d, 5e, 5f auf der Eintrittsfläche 2. Die Linsenaperturen der Linsen 5a, 5b, 5c, 5d, 5e, 5f auf der Eintrittsfläche 2 liegen symmetrisch zu den Emittern, wohingegen die Linsenaperturen der Linsen 7a, 7b, 7c, 7d, 7e, 7f auf der Austrittsfläche 3 in Y-Richtung gestapelt sind.

### Beispiel 1:

Das in den Fig. 10 bis 13 abgebildete Ausführungsbeispiel kann das Licht eine Minibarrens mit 10 Emittern einer Breite in X-Richtung von 100 µm und einem Mittenabstand von 500 µm sowie einer Wellenlänge von 976 in eine Lichtleitfaser einkoppeln, die einen Kerndurchmesser von 100µm und eine NA von 0,15 aufweist.

Die Koppeleffizienz für eine Ausgestaltung des Bauteils aus Quarzglas beträgt dabei laut Simulation 76 % für den gesamten Minibarren (85% für die mittleren Emitter und 64% für die beiden äußeren Emitter).

Die Faser ist in dem Beispiel insbesondere so gewählt, dass sie als Pumpquelle für Faserlaser dienen kann. Eine andere Anwendung betrifft Minibarren mit einer Wellenlänge von etwa 640 nm für Laserprojektoren für ein Kino.

Wenn für das Bauteil ein sehr hoch brechendes Material wie beispielsweise S-TIH53 verwendet wird, wird sich wahrscheinlich eine höhere Koppeleffizienz ergeben.

## Patentansprüche

1. Vorrichtung zur Formung von Laserstrahlung (10a, 10b, 10c, 10d, 10e), umfassend
- ein Bauteil (1) mit einer Eintrittsfläche (2) und einer Austrittsfläche (3),
- ein erstes Linsenarray (4) auf der Eintrittsfläche (2) zur Ablenkung und/oder Abbildung und/oder Kollimation der Laserstrahlung (10a, 10b, 10c, 10d, 10e, 10f), das eine Mehrzahl von in einer ersten Richtung (X) nebeneinander angeordneten Linsen (5a, 5b, 5c, 5d, 5e, 5f) aufweist, wobei unterschiedliche Linsen (5a, 5b, 5c, 5d, 5e, 5f) des ersten Linsenarrays (4) eine unterschiedliche keilförmige Struktur hinsichtlich einer zweiten, zu der ersten Richtung (X) senkrechten, Richtung (Y) aufweisen, sowie
- ein zweites Linsenarray (6) auf der Austrittsfläche (3) zur Ablenkung und/oder Abbildung und/oder Kollimation der Laserstrahlung (10a, 10b, 10c, 10d, 10e, 10f), das eine Mehrzahl von in der zweiten Richtung (Y) nebeneinander angeordneten Linsen (7a, 7b, 7c, 7d, 7e, 7f) aufweist, wobei unterschiedliche Linsen (7a, 7b, 7c, 7d, 7e, 7f) des zweiten Linsenarrays (6) eine unterschiedliche keilförmige Struktur hinsichtlich der ersten Richtung (X) aufweisen,
- wobei
- das erste Linsenarray (4) so gestaltet ist, dass von einer ersten der Linsen (5a, 5b, 5c, 5d, 5e, 5f) des ersten Linsenarrays (4) die Laserstrahlung (10a, 10b, 10c, 10d, 10e, 10f) hinsichtlich der ersten Richtung (X) und/oder hinsichtlich der zweiten Richtung (Y) unter einem anderen Winkel abgelenkt wird als von einer zweiten der Linsen (5a, 5b, 5c, 5d, 5e, 5f) des ersten Linsenarrays (4),
- und/oder wobei
- das zweite Linsenarray (6) so gestaltet ist, dass von einer ersten der Linsen (7a, 7b, 7c, 7d, 7e, 7f) des zweiten Linsenarrays (6) die Laserstrahlung (10a, 10b, 10c, 10d, 10e, 10f) hinsichtlich der ersten Richtung (X) und/oder hinsichtlich der zweiten Richtung (Y) unter einem anderen Winkel abgelenkt wird als von einer zweiten der Linsen (7a, 7b, 7c, 7d, 7e, 7f) des zweiten Linsenarrays (6)
**dadurch gekennzeichnet, dass** die Linsen (5a, 5b, 5c, 5d, 5e, 5f) des ersten Linsenarrays (4) als Zylinderlinsen oder zylinderähnliche Linsen ausgebildet sind, wobei die Zylinderachsen von mindestens zwei der Zylinderlinsen oder zylinderähnlichen Linsen (5a, 5b, 5c, 5d, 5e, 5f) des ersten Linsenarrays (4) einen Winkel größer 0° und kleiner 25° miteinander einschließen, **und/oder dass** die Linsen (7a, 7b, 7c, 7d, 7e, 7f) des zweiten Linsenarrays (6) als Zylinderlinsen oder zylinderähnliche Linsen ausgebildet sind, wobei die Zylinderachsen von mindestens zwei der Zylinderlinsen oder zylinderähnlichen Linsen (7a, 7b, 7c, 7d, 7e, 7f) des zweiten Linsenarrays (6) einen Winkel größer 0° und kleiner 25° miteinander einschließen.

2. Vorrichtung nach Anspruch 1, **dadurch gekennzeichnet, dass** das erste Linsenarray (4) und/oder das zweite Linsenarray (6) so gestaltet sind, dass durch eine Linse (5a, 5b, 5c, 5d, 5e, 5f) des ersten Linsenarrays (4) hindurchgetretene Laserstrahlung (10a, 10b, 10c, 10d, 10e, 10f) genau durch eine Linse (7a, 7b, 7c, 7d, 7e, 7f) des zweiten Linsenarrays (6) hindurch tritt, wobei insbesondere die Anzahl der Linsen (5a, 5b, 5c, 5d, 5e, 5f) des ersten Linsenarrays (4) der Anzahl der Linsen (7a, 7b, 7c, 7d, 7e, 7f) des zweiten Linsenarrays (6) entspricht.

3. Vorrichtung nach einem der Ansprüche 1 oder 2, **dadurch gekennzeichnet, dass** die Eintrittsfläche (2) in der ersten Richtung (X) ausgedehnter ist als die Austrittsfläche (3) und/oder dass die Austrittsfläche (3) in der zweiten Richtung (Y) ausgedehnter ist als die Eintrittsfläche (2).

4. Vorrichtung nach einem der Ansprüche 1 bis 3, **dadurch gekennzeichnet, dass** die Linsen (5a, 5b, 5c, 5d, 5e, 5f) des ersten Linsenarrays (4) in der zweiten Richtung (Y) versetzt zueinander angeordnet sind und/oder dass die Linsen (7a, 7b, 7c, 7d, 7e, 7f) des zweiten Linsenarrays (6) in der ersten Richtung (X) versetzt zueinander angeordnet sind.

5. Vorrichtung nach einem der Ansprüche 1 bis 4, **dadurch gekennzeichnet, dass** mindestens eine der Zylinderachsen der Zylinderlinsen oder zylinderähnlichen Linsen (5a, 5b, 5c, 5d, 5e, 5f) des ersten Linsenarrays (4) senkrecht zu mindestens einer der Zylinderachsen der Zylinderlinsen oder zylinderähnlichen Linsen (7a, 7b, 7c, 7d, 7e, 7f) des zweiten Linsenarrays (6) ausgerichtet ist.

6. Vorrichtung nach einem der Ansprüche 1 bis 5, **dadurch gekennzeichnet, dass**
- die Zylinderachsen der Zylinderlinsen oder zylinderähnlichen Linsen (5a, 5b, 5c, 5d, 5e, 5f) des ersten Linsenarrays (4) entweder parallel zu der ersten Richtung (X) sind oder einen Winkel von weniger als 45°, vorzugsweise weniger als 35°, insbesondere weniger als 25° mit der ersten Richtung (X) einschließen und/oder dass
- die Zylinderachsen der Zylinderlinsen oder zylinderähnlichen Linsen (7a, 7b, 7c, 7d, 7e, 7f) des zweiten Linsenarrays (6) entweder parallel zu der zweiten Richtung (Y) sind oder einen Winkel von weniger als 45°, vorzugsweise weniger als 35°, insbesondere weniger als 25° mit der zweiten Richtung (Y) einschließen.

7. Vorrichtung nach einem der Ansprüche 1 bis 6, **dadurch gekennzeichnet, dass**
- die Zylinderachsen von mindestens zwei der Zylinderlinsen oder zylinderähnlichen Linsen (5a, 5b, 5c, 5d, 5e, 5f) des ersten Linsenarrays (4) einen Winkel größer 0° und kleiner 15°, insbesondere einen Winkel größer 0° und kleiner 10° miteinander einschließen und/oder dass
- die Zylinderachsen von mindestens zwei der Zylinderlinsen oder zylinderähnlichen Linsen (7a, 7b, 7c, 7d, 7e, 7f) des zweiten Linsenarrays (6) einen Winkel größer 0° und kleiner 15°, insbesondere einen Winkel größer 0° und kleiner 10° miteinander einschließen.

8. Vorrichtung nach einem der Ansprüche 1 bis 7, **dadurch gekennzeichnet, dass** die Vorrichtung zur Formung der von einem Laserdiodenbarren oder einem Stack von Laserdiodenbarren ausgehenden Laserstrahlung (10a, 10b, 10c, 10d, 10e, 10f) dienen kann, wobei die erste Richtung (X) der Slow-Axis und die zweite Richtung (Y) der Fast-Axis entspricht.

9. Vorrichtung nach Anspruch 8, **dadurch gekennzeichnet, dass**
- mindestens eine der Zylinderlinsen oder zylinderähnlichen Linsen (5a, 5b, 5c, 5d, 5e, 5f) des ersten Linsenarrays (4) derart ausgebildet ist, dass sie die von einem Emitter des Laserdiodenbarrens oder des Stacks von Laserdiodenbarren ausgehende Laserstrahlung (10a, 10b, 10c, 10d, 10e, 10f) hinsichtlich der zweiten Richtung (Y) auf die Eintrittsfläche einer Lichtleitfaser abbilden oder hinsichtlich der zweiten Richtung (Y) kollimieren kann und/oder dass
- mindestens eine der Zylinderlinsen oder zylinderähnlichen Linsen (7a, 7b, 7c, 7d, 7e, 7f) des zweiten Linsenarrays (6) derart ausgebildet ist, dass sie die von einem Emitter des Laserdiodenbarrens oder des Stacks von Laserdiodenbarren ausgehende Laserstrahlung (10a, 10b, 10c, 10d, 10e, 10f) hinsichtlich der ersten Richtung (X) auf die Eintrittsfläche einer Lichtleitfaser abbilden oder hinsichtlich der ersten Richtung (X) kollimieren kann.

10. Vorrichtung nach einem der Ansprüche 1 bis 9, **dadurch gekennzeichnet, dass** mindestens eine, insbesondere sämtliche der Linsen (5a, 5b, 5c, 5d, 5e, 5f) des ersten Linsenarrays (4) und/oder dass mindestens eine, insbesondere sämtliche der Linsen (7a, 7b, 7c, 7d, 7e, 7f) des zweiten Linsenarrays (6) sowohl hinsichtlich der ersten Richtung (X), als auch hinsichtlich der zweiten Richtung (Y) gekrümmt sind.

11. Vorrichtung nach einem der Ansprüche 1 bis 10, **dadurch gekennzeichnet, dass** mindestens eine, insbesondere sämtliche der Linsen (5a, 5b, 5c, 5d, 5e, 5f) des ersten Linsenarrays (4) und/oder dass mindestens eine, insbesondere sämtliche der Linsen (7a, 7b, 7c, 7d, 7e, 7f) des zweiten Linsenarrays (6) als Freiformflächen ausgebildet sind.

12. Vorrichtung nach einem der Ansprüche 1 bis 11, **dadurch gekennzeichnet, dass** mindestens eine, insbesondere sämtliche der Linsen (7a, 7b, 7c, 7d, 7e, 7f) des zweiten Linsenarrays (6) in der ersten Richtung (X) breiter, insbesondere mehr als doppelt so breit wie mindestens eine, insbesondere sämtliche der Linsen (5a, 5b, 5c, 5d, 5e, 5f) des ersten Linsenarrays (4) sind.

13. Vorrichtung nach einem der Ansprüche 1 bis 12, **dadurch gekennzeichnet, dass** das Bauteil (1) ein monolithisches Bauteil (1) ist.

## Claims

1. Device for forming laser radiation (10a, 10b, 10c, 10d, 10e), comprising:
- a component (1) with an inlet face (2) and an outlet face (3),
- a first lens array (4) on the inlet face (2) for deflecting and/or focussing and/or collimating the laser radiation (10a, 10b, 10c, 10d, 10e, 10f), which array comprises a plurality of lenses (5a, 5b, 5c, 5d, 5e, 5f) arranged next to each other in a first direction (X), wherein different lenses (5a, 5b, 5c, 5d, 5e, 5f) of the first lens array (4) have a different wedge-shaped structure with respect to a second direction (Y) perpendicular to the first direction (X), and
- a second lens array (6) on the outlet face (3) for deflecting and/or focussing and/or collimating the laser radiation (10a, 10b, 10c, 10d, 10e, 10f), which array has a plurality of lenses (7a, 7b, 7c, 7d, 7e, 7f) arranged next to each other in the second direction (Y), wherein different lenses (7a, 7b, 7c, 7d, 7e, 7f) of the second lens array (6) have a different wedge-shaped structure with respect to the second direction (X),
- wherein
- the first lens array (4) is configured such that the laser radiation (10a, 10b, 10c, 10d, 10e, 10f) is deflected with respect to the first direction (X) and/or with respect to the second direction (Y) by a first of the lenses (5a, 5b, 5c, 5d, 5e, 5f) of the first lens array (4) at a different angle from its deflection by a second of the lenses (5a, 5b, 5c, 5d, 5e, 5f) of the first lens array (4),
- and/or wherein
- the second lens array (6) is configured such that the laser radiation (10a, 10b, 10c, 10d, 10e, 10f) is deflected with respect to the first direction (X) and/or with respect to the second direction (Y) by a first of the lenses (7a, 7b, 7c, 7d, 7e, 7f) of the second lens array (6) at a different angle from its deflection by a second of the lenses (7a, 7b, 7c, 7d, 7e, 7f) of the second lens array (6),
**characterised in that** the lenses (5a, 5b, 5c, 5d, 5e, 5f) of the first lens array (4) are configured as cylinder lenses or cylinder-like lenses, wherein the cylinder axes of at least two of the cylinder lenses or cylinder-like lenses (5a, 5b, 5c, 5d, 5e, 5f) of the first lens array (4) enclose with each other an angle of more than 0° and less than 25°, and/or that the lenses (7a, 7b, 7c, 7d, 7e, 7f) of the second lens array (6) are configured as cylinder lenses or cylinder-like lenses, wherein the cylinder axes of at least two of the cylinder lenses or cylinder-like lenses (7a, 7b, 7c, 7d, 7e, 7f) of the second lens array (6) enclose with each other an angle of more than 0° and less than 25°.

2. Device according to claim 1, **characterised in that** the first lens array (4) and/or the second lens array (6) is/are configured such that a laser radiation (10a, 10b, 10c, 10d, 10e, 10f) which has passed through one lens (5a, 5b, 5c, 5d, 5e, 5f) of the first lens array (4) passes precisely through one lens (7a, 7b, 7c, 7d, 7e, 7f) of the second lens array (6), wherein in particular the number of lenses (5a, 5b, 5c, 5d, 5e, 5f) of the first lens array (4) corresponds to the number of lenses (7a, 7b, 7c, 7d, 7e, 7f) of the second lens array (6).

3. Device according to one of claims 1 or 2, **characterised in that** the inlet face (2) is more extensive in the first direction (X) than the outlet face (3), and/or that the outlet face (3) is more extensive in the second direction (Y) than the inlet face (2).

4. Device according to any of claims 1 to 3, **characterised in that** the lenses (5a, 5b, 5c, 5d, 5e, 5f) of the first lens array (4) are arranged offset to each other in the second direction (Y), and/or that the lenses (7a, 7b, 7c, 7d, 7e, 7f) of the second lens array (6) are arranged offset to each other in the first direction (X).

5. Device according to any of claims 1 to 4, **characterised in that** at least one of the cylinder axes of the cylinder lenses or cylinder-like lenses (5a, 5b, 5c, 5d, 5e, 5f) of the first lens array (4) is oriented perpendicularly to at least one of the cylinder axes of the cylinder lenses or cylinder-like lenses (7a, 7b, 7c, 7d, 7e, 7f) of the second lens array (6).

6. Device according to any of claims 1 to 5, **characterised in that**
- the cylinder axes of the cylinder lenses or cylinder-like lenses (5a, 5b, 5c, 5d, 5e, 5f) of the first lens array (4) are either parallel to the first direction (X) or enclose an angle of less than 45°, preferably less than 35°, in particular less than 25° with the first direction (X), and/or
- the cylinder axes of the cylinder lenses or cylinder-like lenses (7a, 7b, 7c, 7d, 7e, 7f) of the second lens array (6) are either parallel to the second direction (Y) or enclose an angle of less than 45°, preferably less than 35°, in particular less than 25° with the second direction (Y).

7. Device according to any of claims 1 to 6, **characterised in that**
- the cylinder axes of at least two of the cylinder lenses or cylinder-like lenses (5a, 5b, 5c, 5d, 5e, 5f) of the first lens array (4) enclose with each other an angle of more than 0° and less than 15°, in particular an angle of more than 0° and less than 10°, and/or
- the cylinder axes of at least two of the cylinder lenses or cylinder-like lenses (7a, 7b, 7c, 7d, 7e, 7f) of the second lens array (6) enclose with each other an angle of more than 0° and less than 15°, in particular an angle of more than 0° and less than 10°.

8. Device according to any of claims 1 to 7, **characterised in that** the device may serve to form the laser radiation (10a, 10b, 10c, 10d, 10e, 10f) emitted by a laser diode bar or a stack of laser diode bars, wherein the first direction (X) corresponds to the slow axis and the second direction (Y) to the fast axis.

9. Device according to claim 8, **characterised in that**
- at least one of the cylinder lenses or cylinder-like lenses (5a, 5b, 5c, 5d, 5e, 5f) of the first lens array (4) is configured such that it can focus the laser radiation (10a, 10b, 10c, 10d, 10e, 10f) emitted by an emitter of the laser diode bar or stack of laser diode bars with respect to the second direction (Y) onto the inlet face of a light-conductive fibre or collimate said radiation with respect to the second direction (Y), and/or
- at least one of the cylinder lenses or cylinder-like lenses (7a, 7b, 7c, 7d, 7e, 7f) of the second lens array (6) is configured such that it can focus the laser radiation (10a, 10b, 10c, 10d, 10e, 10f) emitted by an emitter of the laser diode bar or stack of laser diode bars with respect to the first direction (X) onto the inlet face of a light-conductive fibre or collimate said radiation with respect to the first direction (X).

10. Device according to any of claims 1 to 9, **characterised in that** at least one, in particular all the lenses (5a, 5b, 5c, 5d, 5e, 5f) of the first lens array (4) and/or at least one, in particular all the lenses (7a, 7b, 7c, 7d, 7e, 7f) of the second lens array (6) is/are curved both with respect to the first direction (X) and also with respect to the second direction (Y).

11. Device according to any of claims 1 to 10, **characterised in that** at least one, in particular all the lenses (5a, 5b, 5c, 5d, 5e, 5f) of the first lens array (4) and/or at least one, in particular all the lenses (7a, 7b, 7c, 7d, 7e, 7f) of the second lens array (6) is/are configured as free-form faces.

12. Device according to any of claims 1 to 11, **characterised in that** at least one, in particular all the lenses (7a, 7b, 7c, 7d, 7e, 7f) of the second lens array (6) is/are wider in the first direction (X), in particular more than twice as wide, than at least one, in particular all the lenses (5a, 5b, 5c, 5d, 5e, 5f) of the first lens array (4).

13. Device according to any of claims 1 to 12, **characterised in that** the component (1) is a monolithic component (1).

## Revendications

1. Dispositif de mise en forme de rayonnement laser (10a, 10b, 10c, 10d, 10e), comprenant
- un composant (1) avec une surface d'entrée (2) et une surface de sortie (3),
- un premier groupe de lentilles (4) sur la surface d'entrée (2), qui est destiné à la déviation et/ou la projection et/ou la collimation du rayonnement laser (10a, 10b, 10c, 10d, 10e, 10f) et qui comporte plusieurs lentilles (5a, 5b, 5c, 5d, 5e, 5f) agencées les unes à côté des autres dans une première direction (X), dans lequel différentes lentilles (5a, 5b, 5c, 5d, 5e, 5f) du premier groupe de lentilles (4) ont une structure cunéiforme différente quant à une deuxième direction (Y) perpendiculaire à la première direction (X), ainsi que
- un deuxième groupe de lentilles (6) sur la surface de sortie (3), qui est destiné à la déviation et/ou la projection et/ou la collimation du rayonnement laser (10a, 10b, 10c, 10d, 10e, 10f) et qui comporte plusieurs lentilles (7a, 7b, 7c, 7d, 7e, 7f) agencées les unes à côté des autres dans la deuxième direction (Y), dans lequel différentes lentilles (7a, 7b, 7c, 7d, 7e, 7f) du deuxième groupe de lentilles (6) ont une structure cunéiforme différente quant à la première direction (X),
dans lequel
- le premier groupe de lentilles (4) est configuré de telle sorte que, par rapport à la première direction (X) et/ou à la deuxième direction (Y), le rayonnement laser (10a, 10b, 10c, 10d, 10e, 10f) est dévié par une première lentille parmi les lentilles (5a, 5b, 5c, 5d, 5e, 5f) du premier groupe de lentilles (4) sous un autre angle que par une deuxième lentille parmi les lentilles (5a, 5b, 5c, 5d, 5e, 5f) du premier groupe de lentilles (4),
et/ou dans lequel
- le deuxième groupe de lentilles (6) est configuré de telle sorte que, par rapport à la première direction (X) et/ou à la deuxième direction (Y), le rayonnement laser (10a, 10b, 10c, 10d, 10e, 10f) est dévié par une première lentille parmi les lentilles (7a, 7b, 7c, 7d, 7e, 7f) du deuxième groupe de lentilles (6) sous un autre angle que par une deuxième lentille parmi les lentilles (7a, 7b, 7c, 7d, 7e, 7f) du deuxième groupe de lentilles (6),
**caractérisé en ce que** les lentilles (5a, 5b, 5c, 5d, 5e, 5f) du premier groupe de lentilles (4) sont réalisées comme des lentilles cylindriques ou des lentilles semblables à des cylindres,
dans lequel les axes de cylindre d'au moins deux des lentilles cylindriques ou lentilles semblables à des cylindres (5a, 5b, 5c, 5d, 5e, 5f) du premier groupe de lentilles (4) forment entre eux un angle supérieur à 0° et inférieur à 25°,
**et/ou en ce que** les lentilles (7a, 7b, 7c, 7d, 7e, 7f) du deuxième groupe de lentilles (6) sont réalisées comme des lentilles cylindriques ou des lentilles semblables à des cylindres,
dans lequel les axes de cylindre d'au moins deux des lentilles cylindriques ou lentilles semblables à des cylindres (7a, 7b, 7c, 7d, 7e, 7f) du deuxième groupe de lentilles (6) forment entre eux un angle supérieur à 0° et inférieur à 25°.

2. Dispositif selon la revendication 1, **caractérisé en ce que** le premier groupe de lentilles (4) et/ou le deuxième groupe de lentilles (6) sont configurés de telle sorte qu'un rayonnement laser (10a, 10b, 10c, 10d, 10e, 10f) ayant traversé une lentille (5a, 5b, 5c, 5d, 5e, 5f) du premier groupe de lentilles (4) passe à travers exactement une lentille (7a, 7b, 7c, 7d, 7e, 7f) du deuxième groupe de lentilles (6), le nombre des lentilles (5a, 5b, 5c, 5d, 5e, 5f) du premier groupe de lentilles (4) correspondant en particulier au nombre des lentilles (7a, 7b, 7c, 7d, 7e, 7f) du deuxième groupe de lentilles (6).

3. Dispositif selon l'une quelconque des revendications 1 ou 2, **caractérisé en ce que** la surface d'entrée (2) dans la première direction (X) est plus étendue que la surface de sortie (3) et/ou **en ce que** la surface de sortie (3) dans la deuxième direction (Y) est plus étendue que la surface d'entrée (2).

4. Dispositif selon l'une quelconque des revendications 1 à 3, **caractérisé en ce que** les lentilles (5a, 5b, 5c, 5d, 5e, 5f) du premier groupe de lentilles (4) sont agencées décalées les unes par rapport aux autres dans la deuxième direction (Y) et/ou **en ce que** les lentilles (7a, 7b, 7c, 7d, 7e, 7f) du deuxième groupe de lentilles (6) sont agencées décalées les unes par rapport aux autres dans la première direction (X).

5. Dispositif selon l'une quelconque des revendications 1 à 4, **caractérisé en ce qu'**au moins l'un des axes de cylindre des lentilles cylindriques ou semblables à des cylindres (5a, 5b, 5c, 5d, 5e, 5f) du premier groupe de lentilles (4) est orienté perpendiculairement à au moins l'un des axes de cylindre des lentilles cylindriques ou semblables à des cylindres (7a, 7b, 7c, 7d, 7e, 7f) du deuxième groupe de lentilles (6).

6. Dispositif selon l'une quelconque des revendications 1 à 5, **caractérisé en ce que**
- les axes de cylindre des lentilles cylindriques ou semblables à des cylindres (5a, 5b, 5c, 5d, 5e, 5f) du premier groupe de lentilles (4) soit sont parallèles à la première direction (X) soit forment avec la première direction (X) un angle de moins de 45°, de préférence de moins de 35°, en particulier de moins de 25°, et/ou
- les axes de cylindre des lentilles cylindriques ou semblables à des cylindres (7a, 7b, 7c, 7d, 7e, 7f) du deuxième groupe de lentilles (6) soit sont parallèles à la première direction (Y) soit forment avec la première direction (Y) un angle de moins de 45°, de préférence de moins de 35°, en particulier de moins de 25°.

7. Dispositif selon l'une quelconque des revendications 1 à 6, **caractérisé en ce que**
- les axes de cylindre d'au moins deux des lentilles cylindriques ou semblables à des cylindres (5a, 5b, 5c, 5d, 5e, 5f) du premier groupe de lentilles (4) forment entre eux un angle supérieur à 0° et inférieur à 15°, en particulier un angle supérieur à 0° et inférieur à 10°, et/ou
- les axes de cylindre d'au moins deux des lentilles cylindriques ou semblables à des cylindres (7a, 7b, 7c, 7d, 7e, 7f) du deuxième groupe de lentilles (6) forment entre eux un angle supérieur à 0° et inférieur à 15°, en particulier un angle supérieur à 0° et inférieur à 10°.

8. Dispositif selon l'une quelconque des revendications 1 à 7, **caractérisé en ce que** le dispositif peut servir à mettre en forme le rayonnement laser (10a, 10b, 10c, 10d, 10e, 10f) partant d'une barre de diodes lasers ou d'une pile de barres de diodes lasers, la première direction (X) correspondant à l'axe lent et la deuxième direction (Y) à l'axe rapide.

9. Dispositif selon la revendication 8, **caractérisé en ce que**
- au moins l'une des lentilles cylindriques ou semblables à des cylindres (5a, 5b, 5c, 5d, 5e, 5f) du premier groupe de lentilles (4) est conçue de telle sorte qu'elle peut projeter le rayonnement laser (10a, 10b, 10c, 10d, 10e, 10f) partant d'un émetteur de la barre de diodes lasers ou de la pile de barres de diodes lasers, par rapport à la deuxième direction (Y), sur la surface d'entrée d'une fibre optique ou la collimater par rapport à la deuxième direction (Y) et/ou
- au moins l'une des lentilles cylindriques ou semblables à des cylindres (7a, 7b, 7c, 7d, 7e, 7f) du deuxième groupe de lentilles (6) est conçue de telle sorte qu'elle peut projeter le rayonnement laser (10a, 10b, 10c, 10d, 10e, 10f) partant d'un émetteur de la barre de diodes lasers ou de la pile de barres de diodes lasers, par rapport à la première direction (X), sur la surface d'entrée d'une fibre optique ou la collimater par rapport à la première direction (X).

10. Dispositif selon l'une quelconque des revendications 1 à 9, **caractérisé en ce qu'**au moins l'une des et en particulier toutes les lentilles (5a, 5b, 5c, 5d, 5e, 5f) du premier groupe de lentilles (4) et/ou au moins l'une des et en particulier toutes les lentilles (7a, 7b, 7c, 7d, 7e, 7f) du deuxième groupe de lentilles (6) sont courbes aussi bien par rapport à la première direction (X) que par rapport à la deuxième direction (Y).

11. Dispositif selon l'une quelconque des revendications 1 à 10, **caractérisé en ce qu'**au moins l'une des et en particulier toutes les lentilles (5a, 5b, 5c, 5d, 5e, 5f) du premier groupe de lentilles (4) et/ou au moins l'une des et en particulier toutes les lentilles (7a, 7b, 7c, 7d, 7e, 7f) du deuxième groupe de lentilles (6) sont réalisées comme des surfaces de forme libre.

12. Dispositif selon l'une quelconque des revendications 1 à 11, **caractérisé en ce qu'**au moins l'une des et en particulier toutes les lentilles (7a, 7b, 7c, 7d, 7e, 7f) du deuxième groupe de lentilles (6) sont plus larges, en particulier plus de deux fois plus larges, dans la première direction (X) qu'au moins l'une des et en particulier toutes les lentilles (5a, 5b, 5c, 5d, 5e, 5f) du premier groupe de lentilles (4).

13. Dispositif selon l'une quelconque des revendications 1 à 12, **caractérisé en ce que** le composant (1) est un composant (1) monolithique.
